# EUROPEAN PATENT APPLICATION

(11) **EP 1 826 612 A1**
(43) Date of publication of application: **29.08.2007**
(21) Application number: 07102793.2
(22) Date of filing: 21.02.2007
(51) Int. Cl.: G03F 7/039

(54) **Radiation-sensitive positive resin composition for producing platings, transfer film, and process for producing platings**

(30) Priority: 22.02.2006 JP 2006045301
(71) Applicant: JSR Corporation, Tokyo 104-0045 (JP)
(72) Inventor: Mori, Kousuke, 104-0045 Tokyo (JP); Nishikawa, Kouji, 104-0045 Tokyo (JP)
(74) Representative: TBK-Patent

(57) **Abstract**

A radiation-sensitive positive resin composition is excellent in sensitivity, resolution and adhesion to a substrate and is developed to form clear apertures without residues. The composition does not contaminate a plating solution and is capable of forming a resin film (resist) that is resistant to cracks after plating, resistant to indentation by platings, and resistant to lifting. A transfer film has the composition. A process of the invention produces thick platings as bumps or wirings with high precision.

The radiation-sensitive positive resin composition for producing platings includes a polymer (A) that has at least one end terminated with -SR (wherein R is a linear or branched alkyl group of 1 to 20 carbon atoms, a cyclic alkyl group of 3 to 20 carbon atoms, or a derivative thereof) and includes a structural unit having an acid-dissociative functional group which is dissociated by an acid to yield an acidic functional group; a radiation-sensitive acid generator (B); and an organic solvent (C).

## Description

### FIELD OF THE INVENTION

The present invention relates to a radiation-sensitive positive resin composition suited for producing platings, a transfer film with the composition, and a process for producing platings using the composition.

### BACKGROUND OF THE INVENTION

The miniaturization of integrated circuit elements has brought rapid transitions to higher densities of large scale integration (LSI) chips and to integrated circuits customized for particular uses (application specific integrated circuit (ASIC)). Such transitions entail multi-pin thin film technology which is a technique for mounting LSI chips on electronic devices, and bare chip mounting methods such as tape automated bonding (TAB) and flip chip bonding are increasingly accepted, In the multi-pin thin film technology, protruded electrodes called bumps that are 10 µm or more in height should be arranged as connecting terminals with high precision on the substrate.

Such bumps are usually formed as follows. A wafer is provided on which LSI circuits are formed, and a barrier metal as a conductive layer is provided on the wafer. Thereafter, a radiation-sensitive resin composition (resist) is applied on the barrier metal, followed by drying. The composition is irradiated with radiation (hereinafter, also referred to as "exposed") through a mask having an aperture pattern corresponding to bumps to be produced. The latent image is developed to produce a pattern and, with the pattern as a template, an electrode material such as gold or copper is deposited by electroplating. The resin is released, and the barrier metal is etched to form bumps. The wafer is then cut into square chips, followed by packaging such as TAB or mounting such as flip chip bonding.

The resist used in the bump production has the following requirements.
(1) The resist forms a film having a uniform thickness of 20 µm or more.
(2) The resist has high resolution to cope with smaller pitches between bumps.
(3) The resist forms a pattern as a template with nearly perpendicular sidewalls, and the pattern has high fidelity to the size of the apertures of the mask.
(4) The resist has high sensitivity and developability to increase the production efficiency.
(5) The resist has good wettability with a plating solution.
(6) The resist is not dissolved in the plating solution during the plating and does not deteriorate the plating solution.
(7) The resist has high adhesion to the substrate to prevent the plating solution from leaking in between the substrate and the resist.
(8) After plating, the resist is easily released with a releasing solution.
   Further, the platings obtained by plating have the following requirement.
(9) The platings have high fidelity to the shape of the template pattern and to the size of the apertures of the mask.

Known bump-forming resists include radiation-sensitive positive resin compositions containing a novolak resin and a naphthoquinonediazide, (See JP-A-2000-250210 (Patent Document 1) .) Developing a resist of the composition results in a pattern in which the aperture sidewalls are tapered (forward tapered) from near the substrate to the resist surface and are consequently not perpendicular. Moreover, the resist of the composition has low sensitivity and requires a long exposure time, causing bad production efficiency. Furthermore, the resolution and the fidelity of the thick platings to the aperture size of the mask are insufficient.

JP-A-2001-281862 (Patent Document 2) discloses a radiation-sensitive positive resin composition as a bump-forming resist. This composition contains a polymer having an acid-dissociative functional group which is dissociated by an acid to yield an acidic functional group, a radiation-sensitive acid generator, and other additives. The composition forms a resist having excellent sensitivity and resolution. According to JP-A-2001-281863 (Patent Document 3), an alkali-soluble resin with a specific structure is used in the above composition and as a result the resist shows increased adhesion to prevent a gold plating solution from leaking in between the substrate and the resist. The alkali-soluble resin also reduces cracks when the resist film is expanded or shrunk during the plating.

The present inventors have found that by introducing a crosslinked structure in the polymer having an acid-dissociative functional group which is dissociated by an acid to yield an acidic functional group, gold is deposited through the patterned resist at high temperatures while the gold platings are not larger than the aperture size (i.e., the gold platings do not indent the apertures). However, it has been found that the resist has insufficient adhesion to the substrate and is consequently lifted when it is expanded during the plating with in particular gold cyanide.

JP-A-H10-207067 (Patent Document 4) discloses a far ultraviolet-sensitive positive photoresist composition that contains a resin having a thioester group in a side chain. When this composition is exposed, an acid is generated and dissociates sulfur-containing dissociative groups, and the dissociated groups contaminate the gold plating solution, resulting in excessively increased hardness of gold. Moreover, when the resin having a thioester group in a side chain is polymerized, some sulfur-containing monomers remain unreacted and contaminate the gold plating solution, resulting in excessively increased hardness of gold.
[Patent Document 1] JP-A-2000-250210
[Patent Document 2] JP-A-2001-281862
[Patent Document 3] JP-A-2001-281863
[Patent Document 4] JP-A-H10-207067

### DISCLOSURE OF THE INVENTION

It is an object of the invention to provide a radiation-sensitive positive resin composition which is excellent in sensitivity, resolution and adhesion to a substrate and which is developed to form clear apertures without residues, does not contaminate a plating solution, is capable of forming a resin film (resist) that is resistant to cracks after plating, resistant to indentation by platings, and resistant to lifting. It is another object of the invention to provide a transfer film having the composition. It is a further object of the invention to provide a high-precision process for producing thick platings as bumps or wirings.

The present inventors studied diligently in view of the problems in the art, and they have found that the problems are solved by introducing a sulfur-containing group at a terminal of a polymer having an acid-dissociative functional group which is dissociated by an acid to yield an acidic functional group.

A radiation-sensitive positive resin composition for producing platings according to the present invention comprises:
a polymer (A) that has at least one end terminated with -SR (wherein R is a linear or branched alkyl group of 1 to 20 carbon atoms, a cyclic alkyl group of 3 to 20 carbon atoms, or a derivative thereof) and includes a structural unit having an acid-dissociative functional group which is dissociated by an acid to yield an acidic functional group;
a radiation-sensitive acid generator (B); and
an organic solvent (C).

The polymer (A) may be obtained using a chain transfer agent represented by Formula (1):

R-SH (1)

wherein R is a linear or branched alkyl group of 1 to 20 carbon atoms, a cyclic alkyl group of 3 to 20 carbon atoms, or a derivative thereof.

Preferably, the polymer (A) further includes a structural unit represented by Formula (2) and/or a structural unit represented by Formula (3): 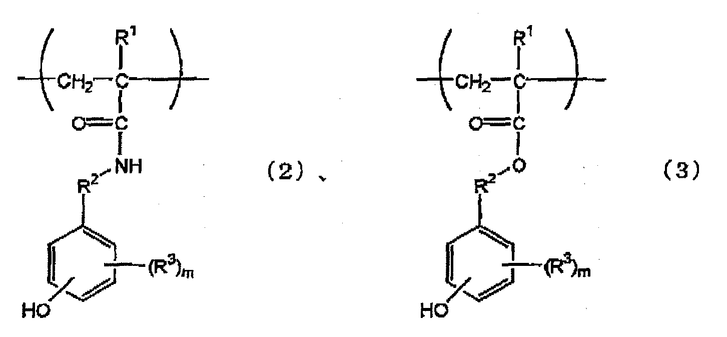 wherein R¹ are independently a hydrogen atom or a methyl group, R² are each -(CH₂)ⱼ- (wherein j is an integer of 0 to 3), R³ are independently a hydrogen atom or an alkyl group of 1 to 4 carbon atoms, and m are each an integer of 1 to 4.

The structural unit having an acid-dissociative functional group of the polymer (A) is preferably represented by Formula (4): 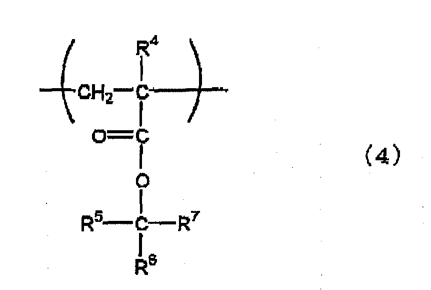 wherein R⁴ is a hydrogen atom or a methyl group; R⁵ to R⁷ are independently an alkyl group of 1 to 4 carbon atoms, an alicyclic hydrocarbon group of 4 to 20 carbon atoms, an aromatic group, or a substituted hydrocarbon group obtained by substituting at least one hydrogen atom in the above groups with a polar group other than hydrocarbon groups; and when any two of R⁵ to R⁷ are the alkyl groups or substituted alkyl groups, the alkyl chains may be linked together to form an alicyclic hydrocarbon group or a substituted alicyclic hydrocarbon group of 4 to 20 carbon atoms.

The polymer (A) is preferably a copolymer that includes a structural unit derived from a monomer with two or more ethylenically unsaturated double bonds.

Preferably, the radiation-sensitive positive resin composition for producing platings according to the invention includes an alkali-soluble resin other than the polymer (A), and an acid diffusion controller.

The radiation-sensitive positive resin composition is suitably used for producing bumps.

A resin film according to the present invention is formed from the radiation-sensitive positive resin composition and has a thickness of 20 to 100 µm.

A transfer film according to the present invention comprises a support film and the resin film on the support film.

A process for producing platings according to the present invention comprises the steps of:
(1) providing a resin film on a wafer having a barrier metal layer, the resin film comprising the radiation-sensitive positive resin composition;
(2) exposing the resin film to light and developing a latent image to form a pattern;
(3) depositing an electrode material by electroplating using the pattern as a template; and
(4) releasing the remaining resin film and etching the barrier metal layer.

The resin film in the step (1) is preferably provided on the wafer by transferring the resin film of the transfer film.

The radiation-sensitive positive resin composition for producing platings according to the present invention possesses excellent sensitivity and resolution and can form a pattern as an electroplating template with higher fidelity to the size of apertures of a mask. Further, the composition forms a resin film that is hard and resistant to deformation. Consequently, the template pattern enables platings to be electroplated faithfully to the shape and size of the apertures of the mask. Moreover, the composition shows high adhesion to a substrate, and the resist film of the composition is resistant to cracks during or after plating and is not lifted. The radiation-sensitive positive resin composition is highly suited for producing thick platings such as bumps or wirings in integrated circuit elements (e.g., LCD driver IC). Furthermore, the bleeding out of the sulfur-containing compound from the composition during the plating is small, and the composition does not contaminate the plating solution.

### PREFERRED EMBODIMENTS OF THE INVENTION

The radiation-sensitive positive resin composition for producing platings, the transfer film having a resin film of the composition, and the process for producing platings using the composition and the transfer film will be described in detail

### [Radiation-sensitive positive resin composition for producing platings]

The radiation-sensitive positive resin composition for producing platings according to the present invention comprises:
a polymer (A) that has at least one end terminated with -SR and includes a structural unit having an acid-dissociative functional group which is dissociated by an acid to yield an acidic functional group;
a radiation-sensitive acid generator (B);
an organic solvent (C); and
other components as required.

The letter R in -SR refers to a linear or branched alkyl group of 1 to 20 carbon atoms, a cyclic alkyl group of 3 to 20 carbon atoms, or a derivative thereof.

### (A) Polymer

The polymer (A) used in the invention has at least one end terminated with -SR and includes a structural unit having an acid-dissociative functional group which is dissociated by an acid to yield an acidic functional group. The polymer (A) terminated with -SR enables the composition to form a resin film (resist) which shows improved adhesion to a substrate, in particular improved adhesion to a substrate after gold cyanide is deposited therethrough, and which is not lifted.

The terminal SR group may be introduced into the polymer (A) by using a compound of Formula (1) (hereinafter, the compound (I)) as a chain transfer agent.

R-SH (1)

In Formula (1), R is a linear or branched alkyl group of 1 to 20 carbon atoms, a cyclic alkyl group of 3 to 20 carbon atoms, or a derivative thereof.

When the polymer (A) is synthesized using the compound (I) as chain transfer agent, the polymer contains little unreacted sulfur-containing compound as compared when a sulfur-containing compound as a monomer is polymerized. Consequently, the composition does not contaminate the plating solution.

Examples of the compounds (I) include n-dodecylmercaptan, t-dodecylmercaptan, n-octadecylmercaptan, trimethylolpropane tris(3-mercaptopropionate) and pentaerythritol tetrakis(3-mercaptopropionate).

The composition includes a component (B) that generates an acid when exposed to light (hereinafter, the acid generator) . The acid generated by exposure reacts with the acid-dissociative functional group of the polymer (A) to produce an acidic functional group and an acid-dissociated residual substance. The decomposition of the acid-dissociative functional group is accelerated by heating the exposed composition (hereinafter, post exposure baking (PEB)). Consequently, the exposed regions of the polymer increase solubility with aqueous alkaline solutions, and desired patterns can be formed with high sensitivity (namely, in a low exposure dose) and high resolution.

The acid-dissociative functional group is not particularly limited as long as it is dissociated by an acid to yield an acidic functional group. Examples thereof include functional groups dissociated by an acid to yield carboxyl groups or phenolic hydroxyl groups. Preferred examples of the structural units having the acid-dissociative functional group include those represented by Formula (4): 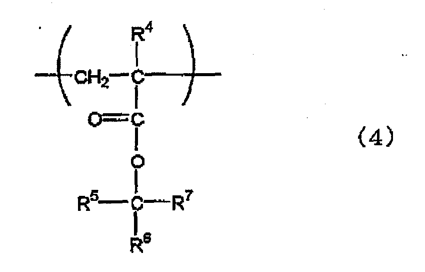 wherein R⁴ is a hydrogen atom or a methyl group; R⁵ to R⁷, which may be the same or different, are independently an alkyl group of 1 to 4 carbon atoms, an alicyclic hydrocarbon group of 4 to 20 carbon atoms, an aromatic group, or a substituted hydrocarbon group obtained by substituting at least one hydrogen atom in the above groups with a polar group other than hydrocarbon groups; and when any two of R⁵ to R⁷ are the alkyl groups or substituted alkyl groups, the alkyl chains may be linked together to form an alicyclic hydrocarbon group or a substituted alicyclic hydrocarbon group of 4 to 20 carbon atoms.

The acid-dissociative functional group in the structural unit of Formula (4) is decomposed by the acid generated by UV exposure and the decomposition is accelerated by the post exposure baking. Consequently, an acidic functional group and an acid-dissociated residual substance are produced, and the polymer increases solubility with aqueous alkaline solutions.

The structural units represented by Formula (4) are derived from monomers represented by Formula (4a) (hereinafter, the monomers (4')): 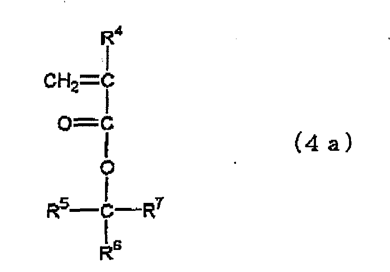 wherein R⁴ to R⁷ are as defined in Formula (4).

The alkyl groups of 1 to 4 carbon atoms may be linear or branched, with examples including methyl, ethyl, n-propyl, i-propyl, n-butyl, 2-methylpropyl, 1-methylpropyl and t-butyl.

Examples of the monovalent alicyclic hydrocarbon groups of 4 to 20 carbon atoms, and divalent alicyclic hydrocarbon groups of 4 to 20 carbon atoms that occur when any two alkyl chains of R⁵ to R⁷ are linked together include cycloalkanes such as cyclobutane, cyclopentane, cyclohexane, cycloheptane and cyclooctane; and groups derived from bridge-containing hydrocarbons, such as adamantane, bicyclo[2.2.1]heptane, tetracyclo[6.2.1.1^{3,6}.0^{2,7}] dodecane and tricyclo[5.2.1.0^{2,6}]decane. These cycloalkanes and groups derived from bridge-containing hydrocarbons may be substituted with Cl-4 linear or branched alkyl groups or C3-4 cyclic alkyl groups, such as methyl, ethyl, n-propyl, i-propyl, n-butyl, 2-methylpropyl, 1-methylpropyl and t-butyl.

Examples of the aromatic groups include phenyl, o-tolyl, m-tolyl, p-tolyl, 4-chlorophenyl, 4-t-butylphenyl, 1-naphthyl and benzyl,

Examples of the substituent groups in the substituted hydrocarbon groups, namely, the polar groups other than hydrocarbon groups capable of substituting for hydrogen include hydroxyl group; carboxyl groups; oxo group (=0 group) ; hydroxyalkyl groups such as hydroxymethyl, 1-hydroxyethyl, 2-hydroxyethyl, 1-hydroxypropyl, 2-hydroxypropyl, 3-hydroxypropyl, 2-hydroxybutyl, 3-hydroxybutyl and 4-hydroxybutyl; alkoxyl groups such as methoxy, ethoxy, n-propoxy, i-propoxy, n-butoxy, 2-methy7.propoxy, 1-methylpropoxy and t-butoxy; cyano group; and cyanoalkyl groups such as cyanomethyl, 2-cyanoethyl, 3-cyanopropyl and 4-cyanobutyl.

Examples of the monomers (4') include t-butyl (meth)acrylate, 1,1-dimethyl-propyl (meth)acrylate, 1,1-dimethyl-butyl (meth)acrylate, 2-cyclohexylpxopyl (meth)acrylate, 1,1-dimethyl-phenyl (meth)acrylate, tetrahydropyranyl (meth)acrylate, 2-t-butoxycarbonylmethyl (meth)acrylate, 2-benzyloxycarbonylethyl (meth)acrylate, 2-methyladamantyl (meth)acrylate, 1,1-dimethyl-3-axobutyl (meth)acrylate and 2-benzylpropyl (meth)acrylate.

Alternatively to the monomers (4'), the structural units having the acid-dissociative functional group may be derived from monomers that are dissociated by an acid to yield phenolic hydroxyl groups. Examples of such monomers include acetal-protected hydroxystyrenes such as p-1-methoxyethoxystyrene and p-1-ethoxyethoxystyrene; t-butoxystyrene and t-butoxycarbonyloxystyrene.

These monomers may be used singly or in combination of two or more kinds. Of the monomers capable of giving the structural units having the acid-dissociative functional group, 1,1-dimethyl-3-oxobutyl (meth)acrylate and 2-benzylpropyl (meth)acrylate are preferred.

Preferably, the polymer (A) further includes a structural unit represented by Formula (2) and/or a structural unit represented by Formula (3) (hereinafter, the structural unit (2) and the structural unit (3), respectively): 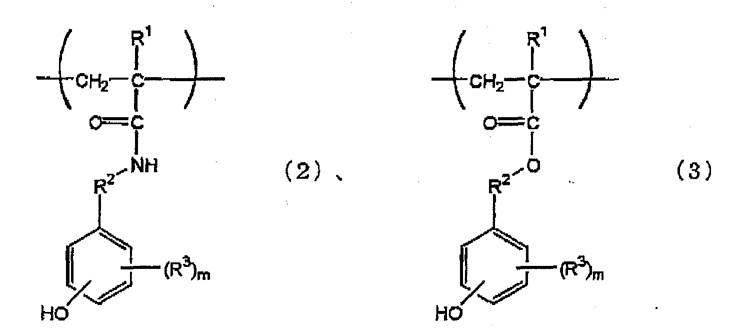 wherein R¹ are independently a hydrogen atom or a methyl group, R² are each -(CH₂)ⱼ- (wherein j is an integer of 0 to 3), R³ are independently a hydrogen atom or an alkyl group of 1 to 4 carbon atoms, and m are each an integer of 1 to 4.

By the polymer (A) containing the structural unit (s) (2) and/or (3), the resist shows good adhesion to a substrate and prevents the plating solution from leaking in between the substrate and the resist. The structural unit (2) includes an amide group which functions as a weak alkali in the resist film to inhibit deactivation of the acid by environmental amines. Controlling the types and numbers of the substituent groups in the structural units (2) and (3) alters the acidity of the phenolic hydroxyl groups, and consequently the solubility of the resist with respect to alkaline developers is controlled.

The structural units (2) and (3) may be derived from monomers represented by Formulae (2a) and (3a) respectively (hereinafter, the monomer (2') and the monomer (3')): 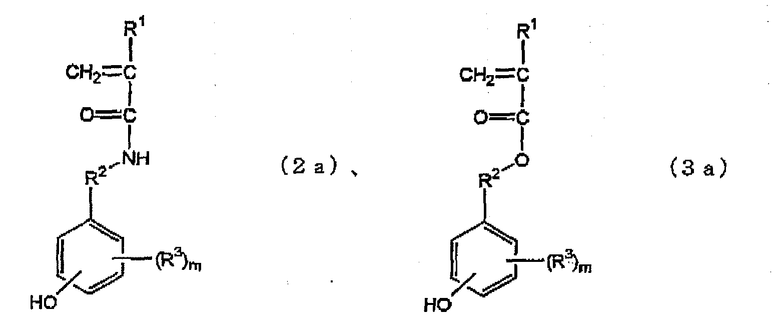 wherein R¹ to R³ are as defined in Formulae (2) and (3).

Examples of the monomers (2') include amide-containing vinyl compounds such as p-hydroxyphenyl acrylamide, p-hydroxyphenyl methacrylamide, o-hydroxyphenyl acrylamide, o-hydroxyphenyl methacrylamide, m-hydroxyphenyl acrylamide, m-hydroxyphenyl methacrylamide, p-hydroxybenzyl acrylamide, p-hydroxybenzyl methacrylamide, 3,5-dimethyl-4-hydroxybenzyl acrylamide, 3,5-dimethyl-4-hydroxybenzyl methacrylamide, 3,5-dz-t-butyl-4-hyd.roxybenzyl acrylamide, 3,5-di-t-butyl-4-hydroxybenzyl methacrylamide, o-hydroxybenzyl acrylamide and o-hydroxybenzyl methacrylamide.

Examples of the monomers (3') include (meth)acrylates such as p-hydroxyphenyl (meth)acrylate, o-hydroxyphenyl (meth)acrylate, m-hydroxyphenyl (meth)acrylate, p-hydroxybenzyl (meth)acrylate, 3,5-dimethyl-4-hydroxybenzyl (meth)acrylate, 3,5-di-t-butyl-4-hydroxybenzyl (meth)acrylate and o-hydroxybenzyl (meth)acrylate.

The monomers (2') and (3') may be used singly or in combination of two or more kinds. Of the monomers (2') and (3'), p-hydroxyphenyl acrylamide, p-hydroxyphenyl methacrylamide, 3,5-dimethyl-4-hydroxybenzyl acrylamide, 3,5-dimethyl-4-hydroxybenzyl methacrylamide, p-hydroxyphenyl methacrylate and p-hydroxybenzyl methacrylate are preferred.

The polymer (A) preferably has a crosslinked structure, which may be produced by copolymerizing the above-described monomer with a monomer having two or more ethylenically unsaturated double bonds (hereinafter, the monomer (II)). Such polymer (A) provides a crosslinked structure in the resin film to make the film solid, and the solid resin film allows for deposition of metal columns with perpendicular sidewalls.

Examples of the monomers (II) include poly(meth)acrylates such as trimethylolpropane tri(meth)acrylate, ethylene glycol di(meth)acrylate, tetraethylene glycol di(meth)acrylate, polyethylene glycol di(meth)acrylate, 1,4-butanediol di(meth)acrylate, butylene glycol di(meth)acrylate, propylene glycol di(meth)acrylate, trimethylolpropane di(meth)acrylate, 1,6-hexanediol di(meth)acrylate, 2,5-dimethyl-2,5-hexanediol diacrylate, neopentyl glycol di(meth)acrylate, tris(2-hydroxyethyl)isocyanurate tri(meth)acrylate, tris(2-hydroxyethyl)isocyanurate di(meth)acrylate, tricyclodecanedimethanol di(meth)acrylate, epoxy (meth)acrylate obtained by adding (meth)acrylic acid to diglycidyl ether of bisphenol A, bisphenol A-di(meth)acryloyloxyethyl ether, bisphenol A-di(meth)acryloyloxy ethyloxy ethyl ether, bisphenol A-di(meth)acryloyloxy methyl ethyl ether, tetramethylolpropane tetra(meth)acrylate, pentaerythritol tri(meth)acrylate, pentaerythritol tetra(meth)acrylate, dipentaerythritol penta(meth)acrylate and dipentaerythritol hexa(meth)acrylate.

Commercially available compounds may be used as the monomers (II). Examples thereof include compounds commercially available under the trade names of ARONIX series M-210, M-309, M-310, M-400, M-7100, M-8030, M-8060, M-8100, M-9050, M-240, M-245, M-6100, M-6200, M-6250, M-6300, M-6400 and M-6500 (manufactured by Toagosei Co., Ltd.); KAYARAD series R-551, R-712, TMPTA, HDDA, TPGDA, PEG400DA, MANDA, HX-220, HX-620, R-604, DPCA-20, DPCA-30, DPCA-60 and DPCA-120 (manufactured by Nippon Kayaku Co., Ltd.); and BISCOAT series Nos. 295, 300, 260, 312, 335HP, 360, GPT, 3PA and 400 (manufactured by Osaka organic Chemical Industry Ltd.).

These monomers (II) may be used singly or in combination of two or more kinds. Of the monomers (II), trimethylolpropane tri(meth)acrylate, ethylene glycol di(meth)acrylate, 1,4-butanediol di(meth)acrylate and 1,6-hexanediol di(meth)acrylate are preferred.

Production of the polymer (A) may involve a monomer (hereinafter, the monomer (III)) that is copolymerizable with the compound (I), the monomer capable of giving the structural unit having the acid-dissociative functional group, and the optional monomer (2') and/or monomer (3') and monomer (II) having two or more ethylenically unsaturated double bonds.

Examples of the monomers (III) include:
aromatic vinyl compounds such as o-hydroxystyrene, m-hydroxystyrene, p-hydroxystyrene, p-isopropenylphenol, styrene, α-methylstyrene, p-methylstyrene and p-methoxystyrene;
heteroatom-containing alicyclic vinyl compounds such as N-vinylpyrrolidone, N-vinylcaprolactam and acryloylmorpholine;
cyano group-containing vinyl compounds such as acrylonitrile and methacrylonitrile;
conjugated diolefins such as 1,3-butadiene and isoprene;
amide-group containing vinyl compounds such as acrylamide and methacrylamide;
carboxyl group-containing vinyl compounds such as acrylic acid and methacrylic acid; and
(meth)acrylates such as methyl (meth)acrylate, ethyl (meth)acrylate, n-propyl (meth)acrylate, n-butyl (meth)acrylate, 2-hydroxyethyl (meth)acrylate, 2-hydroxypropyl (meth)acrylate, polyethylene glycol mono (meth) acrylate, polypropylene glycol mono (meth) acrylate, glycerol mono(meth)acrylate, phenyl (meth) acrylate, benzyl (meth) acrylate, phenoxypolyethylene glycol (meth) acrylate, cyclohexyl (meth) acrylate, isobornyl (meth) acrylate, tricyclodecanyl (meth)acrylate and phenoxypolyethylene glycol (meth)acrylate.

These monomers (III) may be used singly or in combination of two or more kinds . Of the monomers (III), p-hydroxystyrene, p-isopropenylphenol, styrene, acrylic acid, methacrylic acid, methyl (meth)acrylate, ethyl (meth)acrylate, n-butyl (meth)acrylate, 2-hydroxyethyl (meth)acrylate, 2-hydroxypropyl (meth)acrylate, benzyl (meth)acrylate, isobornyl (meth)acrylate, phenoxypolyethylene glycol (meth)acrylate and acryloylmorpholine are preferred.

The amount of the terminal SR groups in the polymer (A) is preferably in the range of 0.1 to 10 parts by mass, more preferably 0.1 to 5 parts by mass, still more preferably 0.1 to 1 part by mass based on 100 parts by mass of the total of the structural units derived from the monomers (2'), (3'), (4'), (II) and (III), When the amount of the terminal SR groups is less than that described above, the effect produced by the sulfur atoms is small and the resist is often lifted after plating. The compound (I) is preferably used in an amount of 1 to 10 parts by mass, more preferably 1 to 5 parts by mass based on 100 parts by mass of the monomers (2'), (3'), (4'), (II) and (III) combined. When the amount of the compound (I) is more than that described above, unreacted compound (I) may be eluted in the plating solution to contaminate it.

The content of the acid-dissociative functional group in the composition is not particularly limited while still achieving the effects of the invention. For example, when the acid-dissociative functional group is derived from the monomer (4'), the mass ratio of the structural unit derived from the monomer (4') to the structural units derived from the compound (I) and monomers (2'), (3'), (II) and (III) combined is usually in the range of 5/95 to 95/5, preferably 10/90 to 90/10, more preferably 15/85 to 85/15 (monomer (4')/{monomer (2') + monomer (3') + compound (I) + monomer (II) + monomer (III)}). When the ratio of the structural unit derived from the monomer (4') is smaller than that described above, sufficient acidic functional groups are not yielded and the obtainable polymer will show lower solubility in alkaline developers, often resulting in difficult patterning.

When the polymer (A) includes the structural unit(s) derived from the monomer(s) (2') and/or (3'), the mass ratio of the structural unit(s) derived from the monomer(s) (2') and/or (3') to the structural units derived from the compound (I) and monomers (4'), (II) and (III) combined is usually in the range of 1/99 to 50/50, preferably 3/97 to 30/70, more preferably 5/95 to 15/85 ({monomer (2') and/or {monomer (3')} /{monomer (4') + compound (I) + monomer (II) + monomer (III))}}.

When the polymer (A) includes the structural unit derived from the monomer (II), the amount of the structural unit derived from the monomer (II) is preferably in the range of 0.1 to 10 parts by mass, more preferably 0.5 to 5 parts by mass based on 100 parts by mass of the structural units derived from the compound (I) and monomers (2'), (3') (4') and (III) combined. When the amount of the structural unit derived from the monomer (II) is less than that described above, the crosslinking reaction does not take place efficiently and the plating resistance is often not obtained. When the amount exceeds the above range, the polymerization is difficult to control and the excessive gelation or polymerization of resin may result, causing remarkably deteriorated resolution of the resist.

When the polymer (A) includes the structural unit derived from the monomer (III), the mass ratio of the structural unit derived from the monomer (III) to the structural units derived from the compound (I) and monomers (2'), (3'), (4') and (II) combined is usually in the range of 10/90 to 95/5, preferably 30/70 to 90/10, more preferably 50/50 to 80/20 (monomer (III) / {monomer (2') + monomer (3') + monomer (4') + compound (I) + monomer (II)}).

The polymer (A) may be produced by directly copolymerizing the monomer (4'), the compound (I) and optionally the monomer(s) (2') and/or (3'), the monomer (II) and the monomer (III). The polymerization may be performed by radical polymerization, and usual radical polymerization initiators such as organic peroxides may be used. Examples of the polymerization methods include emulsion polymerization, suspension polymerization, solution polymerization and bulk polymerization, with the solution polymerization being particularly preferable.

The solvents for use in the solution polymerization are not particularly limited as long as they do not react with the monomers and can dissolve the polymer formed. Specific examples of the solvents include methanol, ethanol, n-hexane, toluene, tetrahydrofuran, 1,4-dioxane, ethyl acetate, n-butyl acetate, acetone, methyl ethyl ketone, methyl isobutyl ketone, 2-heptanone, cyclohexanone, ethylene glycol monomethyl ether, propylene glycol monomethyl ether, propylene glycol monomethyl ether acetate, methyl 3-methoxypropionate, ethyl 3-ethoxypropionate, ethyl lactate and γ-butyrolactone. These solvents may be used singly or in combination of two or more kinds.

The molecular weight of the polymer (A) may be controlled by appropriately selecting the polymerization conditions such as monomer amounts, radical polymerization initiator, optional molecular weight modifier, and polymerization temperature. The weight-average molecular weight (Mw) in terms of polystyrene of the polymer (A) is usually in the range of 10,000 to 150,000, preferably 20,000 to 100,000. When the polymer (A) has this Mw, the obtainable resin film shows high strength, plating resistance and alkali solubility after exposed to allow for easy formation of fine pattern.

When the polymer (A) is produced by solution polymerization, the polymer solution obtained may be directly used for the preparation of the radiation-sensitive positive resin composition. Alternatively, the polymer (A) may be separated from the polymer solution. In the invention, the polymers (A) may be used singly or in combination of two or more kinds.

### (B) Radiation-sensitive acid generator

The acid generator (B) in the invention is a compound which generates an acid when exposed. By the action of the acid, the acid-dissociative functional group in the polymer (A) is dissociated to yield an acidic functional group such as carboxyl group or phenolic hydroxyl group. As a result, the exposed regions of the resin film formed from the radiation-sensitive positive resin composition are rendered readily soluble in an alkaline developer, resulting in a positive pattern.

Examples of the acid generators (B) include onium salt compounds (including thiophenium salt compounds), halogen-containing compounds, diazoketone compounds, sulfone compounds, sulfonic acid compounds, sulfonimide compounds and diazomethane compounds.

The onium salt compounds include iodonium salts, sulfonium salts, phosphonium salts, diazonium salts and pyridinium salts. Specific and preferred examples thereof include diphenyliodonium trifluoromethanesulfonate, diphenyliodonium p-toluenesulfonate, diphenyliodonium hexafluoroantimonate, diphenyliodonium hexafluorophosphate, diphenyliodonium tetrafluoroborate, triphenylsulfonium trifluoromethanesulfonate, triphenyl hexafluoroantimonate, triphenylsulfonium hexafluorophosphate, 4-t-butylphenyl diphenylsulfonium trifluoromethanesulfonate, 4-t-butylphenyl diphenylsulfonium perfluoro-n-octanesulfonate, 4-t-butylphenyl diphenylsulfonium pyrenesulfonate, 4-t-butylphenyl diphenylsulfonium n-dodecylbenzenesulfonate, 4-t-butylphenyl diphenylsulfonium p-toluenesulfonate, 4-t-butylphenyl diphenylsulfonium benzenesulfonate and 4,7-di-n-butoxynaphthyl tetrahydrothiophenium trifluoromethanesulfonate.

The halogen-containing compounds include haloalkyl group-containing hydrocarbon compounds and haloalkyl group-containing heterocyclic compounds. Specific and preferred examples thereof include 1,10-dibromo-n-decane, 1,1-bis(4-chlorophenyl)-2,2,2-trichloroethane, and (trichloromethyl)-s-triazine derivatives such as phenyl-bis(trichloromethyl)-s-triazine, 4-methoxyphenyl-bis(triohloromethyl)-s-triazine, styryl-bis(trichloromethyl)-s-triazine and naphthyl-bis(trichloromethyl)-s-triazine.

The diazoketone compounds include 1,3-diketo-2-diazo compounds, diazobenzoquinone compounds and diazonaphthoquinone compounds. Specific and preferred examples thereof include 1,2-naphthoquinonediazido-4-sulfonic acid esters of phenols and 1,2-naphthoguinonediazido-5-sulfonic acid esters of phenols.

The sulfone compounds include β-ketosulfones, β-sulfonylsulfones and α-diazo compounds thereof. Specific and preferred examples thereof include 4-trisphenacylsulfone, mesitylphenacylsulfone and bis(phenylsulfonyl)methane.

The sulfonic acid compounds include alkylsulfonates, haloalkylsulfonates, arylsulfonates and iminosulfonates. Specific and preferred examples thereof include benzoin tosylate, pyrogallol tristrifluoromethanesulfonate, o-nitrobenzyl trifluoromethanesulfonate and o-nitrobenzyl-p-toluenesulfonate.

Examples of the sulfonimide compounds include
N-(trifluoromethylsulfonyloxy)succinimide,
N-(trifluoromethylsulfonyloxy)phthalimide,
N-(trifluoromethylsulfonyloxy)diphenylmaleimide,
N-(trifluoromethylsulfonyloxy)bicyclo[2.2.1]hept-5-ene-2,3 -dicarboxyimide,
N-(trifluoromethylsulfonyloxy)-7-oxabicyclo[2.2.1]hept-5-e ne-2,3-dicarboxyimide,
N-(trifluoromethylsulfonyloxy)bicyclo[2.2.1]heptane-5,6-ox y-2,3-dicarboxyimide,
N-(trifluoramethylsulfonyloxy)naphthylimide,
N-(4-methylphenylsulfonyloxy)succinimide,
N- (4-methylphenylsulfonyloxy) phthalimide, N-(4-methylphenylsulfonyloxy)diphenylmaleimide,
N-(4-methylphenylsulfonyloxy)bicyclo[2.2.1]hept-5-ene-2,3-dicarboxyimide,
N-(4-methylphenylsulfonyloxy)-7-oxabicyclo[2.2.1]hept-5-en e-2,3-dicarboxyimide,
N-(4-methylphenylsulfonyloxy)bicyclo[2.2.1]heptane-5,6-oxy -2,3-dicarboxyimide,
N-(4-methylphenylsulfonyloxy)naphthylimide,
N-(2-trifluoromethylphenylsulfonyloxy)succinimide,
N-(2-trifluoromethylphenylsulfonyloxy)phthalimide,
N-(2-trifluoromethylphenylsulfonyloxy)diphenylmaleimide,
N-(2-trifluoromethylphenylsulfonyloxy)bioyclo[2.2.1]hept-5 -ene-2,3-dicarboxyimide,
N-(2-trifluoromethylphenylsulfonyloxy)-7-oxabicyclo[2.2.1] hept-5-ene-2,3-dicarboxyimide,
N-(2-trifluoromethylphenylsulfonyloxy)bicycle[2.2.1]heptan e-5,6-oxy-2,3-dicarboxyimide,
N-(2-trifluorometylphenysulfonyloxy)naphthylimide,
N-(4-fluorophenylsulfonyloxy)succinimide,
N-(4-fluorophenylsulfonyloxy)-7-oxabicyclo[2.1.1]hept-5-en e-2,3-dicarboxyimide,
N-(4-fluorophenylsulfonyloxy)bicyclo[2.1.1]heptane-5,6-oxy -2,3-dicarboxyimide,
N-(4-fluorophenylsulfonyloxy)naphthylimide and
N-(10-camphorsulfonyloxy)naphthylimide.

Examples of the diazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, methylsulfonyl-p-toluenesulfonyldiazomethane, cyclohexylsulfonyl-1,1-dimethylethylsulfonyldiazomethane and bis(1,1-dimethylethylsulfonyl)diazomethane.

The acid generators (B) may be used singly or in combination of two or more kinds. Of these acid generators (B), 4-t-butylphenyl diphenylsulfonium trifluoromethanesulfonate, 4-t-butylphenyl diphenylsulfonium perfluoro-n-octanesulfonate, 4-t-butylphenyl diphenylsulfonium pyrenesulfonate and 4,7-di-n-butoxynaphthyl tetrahydrothiophenium trifluoromethanesulfonate are more preferable, and 4-t-butylphenyl diphenylsulfonium trifluoromethanesulfonate and 4,7-di-n-butoxynaphthyl tetrahydrothiophenium trifluoromethanesulfonate are particularly preferable.

To ensure sensitivity, resolution and pattern configuration of the resist, the acid generator (B) is usually used in an amount of 0.1 to 20 parts by mass, preferably 0.3 to 10 parts by mass, particularly preferably 1 to 5 parts by mass based on 100 parts by mass of the polymer (A). When the acid generator (B) is used in this amount, the obtainable resist shows excellent sensitivity, resolution and transparency to radiation and forms a satisfactory pattern configuration.

### (C) Organic solvent

The radiation-sensitive positive resin composition may be diluted with an organic solvent (C) in order that the polymer (A), the acid generator (B), and optional alkali-soluble resin and additives (described later) will be uniformly mixed together.

Examples of the organic solvents include ethylene glycol alkyl ethers such as ethylene glycol monomethyl ether, ethylene glycol monoethyl ether, ethylene glycol monopropyl ether and ethylene glycol monobutyl ether; diethylene glycol dialkyl ethers such as diethylene glycol dimethyl ether, diethylene glycol diethyl ether, diethylene glycol dipropyl ether and diethylene glycol dibutyl ether; ethylene glycol alkyl acetates such as methyl cellosolve acetate and ethyl cellosolve acetate; propylene glycol alkyl ether acetates such as propylene glycol monomethyl ether acetate, propylene glycol monoethyl ether acetate and propylene glycol monopropyl ether acetate; ketones such as acetone, methyl ethyl ketone, cyclohexanone and methyl amyl ketone; aromatic hydrocarbons such as toluene and xylene; cyclic ethers such as dioxanes; and esters such as methyl 2-hydroxypropionate, ethyl 2-hydroxypropionate, ethyl 2-hydroxy-2-methylpropionate, ethyl 3-ethoxypropionate, ethyl ethoxyacetate, ethyl oxyacetate, methyl 2-hydroxy-3-methylbutanoate, 3-methoxybutyl acetate, 3-methyl-3-methoxybutyl acetate, ethyl formate, ethyl acetate, butyl acetate, methyl acetoacetate and ethyl acetoacetate. The solvents may be used singly or in combination of two or more kinds.

The amount of the organic solvent (C) is not particularly limited as long as the components of the composition are uniformly mixed in view of application methods and uses of the resin composition. Preferably, the solvent is used in an amount such that the solid concentration of the resin composition is from 20 to 65% by mass. Below this level, it is difficult to achieve a film thickness (20 µm or more) ideal for bump-forming materials. When the solid concentration exceeds this range, the composition shows very bad fluidity to cause difficult handling and tends to fail to form a uniform resin film.

### <Alkali-soluble resin>

The radiation-sensitive positive resin composition for producing platings may contain an alkali-soluble resin other than the component (A) as required.

This alkali-soluble resin has one or more functional groups having an affinity for alkaline developers, such as acidic functional groups (e,g., phenolic hydroxyl groups and carboxyl groups), and is soluble in alkaline developers. The addition of the alkali-soluble resin facilitates control of the dissolution rate of the resin film of the composition into alkaline developers, improving developing properties.

The alkali soluble resins are not particularly limited as long as they are soluble in alkaline developers. Examples include addition polymerized resins (other than the polymers (A)) such as o-hydroxystyrene, m-hydroxystyrene, p-hydroxystyrene, p-isopropenylphenol, p-vinylbenzoic acid, p-carboxymethylstyrene and p-carboxymethoxystyrene; addition polymerized resins (other than the polymers (A)) obtained by polymerizing one or more monomers having acidic functional groups, such as acrylic acid, methacrylic acid, crotonic acid, maleic acid, fumaric acid, itaconic acid, citraconic acid, mesaconic acid and cinnamic acid; and polycondensed resins with acidic functional groups represented by novolak resins.

The addition polymerized resins may consist solely of repeating units that are formed by cleavage of polymerizable unsaturated bonds of the monomers with acidic functional groups. The addition polymerized resins may contain one or more other repeating units as long as the resins are soluble in alkaline developers.

Examples of such other repeating units include units derived from styrene, α-methylstyrene, o-vinyltoluene, m-vinyltoluene, p-vinyltoluene, maleic anhydride, acrylonitrile, methacrylonitrile, crotononitrile, maleinonitrile, fumaronitrile, mesacononitrile, citracononitrile, itacononitrile, acrylamide, methacrylamide, crotonamide, maleinamide, fumaramide, mesaconamide, citraconamide, itaconamide, 2-vinylpyridine, 3-vinylpyridine, 4-vinylpyridine, N-vinylaniline, N-vinyl-ε-caprolactam, N-vinylpyrrolidone and N-vinylimidazole.

In particular, poly(p-hydroxystyrene) and copolymers of p-isopropenylphenol are preferable addition polymerized resins because the obtainable resin composition form a film permitting good radiation transmission and having excellent dry etching resistance.

The addition polymerized resins generally range in weight-average molecular weight (Mw) in terms of polystyrene from 1,000 to 200,000, preferably from 5,000 to 70,000.

The polycondensed resins may consist solely of condensed repeating units having acidic functional groups, or may contain other condensed repeating units as long as the resins are soluble in alkaline developers.

The polycondensed resins may be produced by (co)polycondensing at least one phenol, at least one aldehyde and optionally other polycondensing components capable of forming condensed repeating units, in the presence of an acidic or basic catalyst in a water medium or a mixed medium containing water and a hydrophilic solvent.

Examples of the phenols include o-cresol, m-cresol, p-cresol, 2,3-xylenol, 2,4-xylenol, 2,5-xylenol, 3,4-xylenol, 3,5-xylenol, 2,3,5-trimethylphenol and 3,4,5-tximethylphenol. Examples of the aldehydes include formaldehyde, trioxane, paraformaldehyde, benzaldehyde, acetaldehyde, propylaldehyde and phenylacetaldehyde.

The polycondensed resins generally range in weight-average molecular weight (Mw) in terms of polystyrene from 1,000 to 100,000, preferably from 2,000 to 50,000.

These alkali-soluble resins may be used singly or in combination of two or more kinds. The amount of the alkali-soluble resins is usually not more than 200 parts by mass based on 100 parts by mass of the polymer (A).

### <Acid diffusion controller>

The radiation-sensitive positive resin composition preferably contains an acid diffusion controller to control diffusion of the acid generated from the acid generator (B) in the resin film and to prevent undesirable chemical reaction in the unexposed regions. The use of the acid diffusion controller improves storage stability of the composition and resolution of the resist. Moreover, the acid diffusion controller reduces variation of line widths in the pattern due to varied holding periods between the exposure and the PEB, achieving superior processing stability.

The acid diffusion controller is preferably a nitrogen-containing organic compound whose basicity does not change upon exposure or heating in the production of platings.

Examples of the nitrogen-containing organic compounds include n-hexylamine, n-heptylamine, n-octylamine, n-nonylamine, ethylenediamine, N,N,N' ,N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, formamide, N-methylformamide, N,N-dimethylformamide, acetamide, N-methylacetamide, N,N-dimethylacetamide, propionamide, benzamide, pyrrolidone, N-methylpyrrolidone, methylurea, 1,1-dimethylurea, 1,3-dimethylurea, 1,1,3,3-tetramethylurea, 1,3-diphenylurea, imidazole, benzimidazole, 4-methylimidazole, 8-oxyquinoline, acridine, purine, pyrrolidine, piperidine, 2,4,6-tri(2-pyridyl)-s-triazine, morpholine, 4-methylmorpholine, piperazine, 1,4-dimethylpiperazine and 1,4-diazabicyclo[2.2.2]octane. Of these, 2, 4, 6-tri (2-pyridyl) -s-triazine is particularly preferable. The acid diffusion controllers may be used singly or in combination of two or more kinds.

The acid diffusion controller is usually used in an amount of not more than 15 parts by mass, preferably from 0.001 to 10 parts by mass, more preferably from 0.005 to 5 parts by mass based on 100 parts by mass of the polymer (A). This amount of the acid diffusion controller leads to excellent sensitivity, developing properties, pattern configuration and dimensional fidelity of the resist.

### <Surfactant>

The radiation-sensitive positive resin composition may contain a surfactant to improve application properties and developing properties.

Examples of the surfactants include polyoxyethylene lauryl ether, polyoxyethylene stearyl ether, polyoxyethylene oleyl ether, polyoxyethylene n-octylphenol ether, polyoxyethylene n-nonylphenol ether, polyethylene glycol dilaurate and polyethylene glycol distearate.

These surfactants may be used singly or in combination of two or more kinds. The amount of the surfactants is usually not more than 2 parts by mass based on 100 parts by mass of the polymer (A).

### <Other additives>

The radiation-sensitive positive resin composition of the invention may further contain other additives such as ultraviolet absorbers, sensitizers, dispersants, plasticizers, and thermal polymerization inhibitors and antioxidants for enhancing storage stability. Of these, the ultraviolet absorbers are beneficial because they inhibit photoreaction caused by light scattered into the unexposed regions during the exposure. As the ultraviolet absorbers, compounds having a high absorption coefficient in the UV wavelength regions used for the exposure are preferable. Organic pigments are also usable for this purpose.

Terminal-modified or terminal-unmodified vinyl alkyl ether resins and terminal-modified polyether resins may be used to improve the pattern configuration and to reduce cracks in the resin film.

### (Vinyl alkyl ether resins)

Examples of the terminal-modified vinyl alkyl ether resins include polymers and oligomers represented by Formula (5): 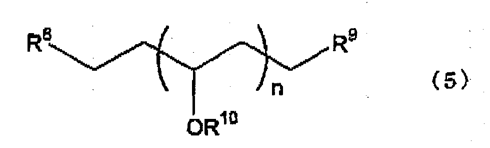 wherein R⁸ and R⁹ are independently a methyl group, a hydroxyl group or a carboxyl group, preferably both hydroxyl groups or methyl groups; and R¹⁰ is an alkyl group of 1 to 4 carbon atoms. Examples of the alkyl groups include methyl, ethyl, n-propyl, isopropyl, n-butyl and isobutyl, with methyl and ethyl being preferable, and ethyl being particularly preferable.

When the radiation-sensitive positive resin composition contains the terminal-modified or terminal-unmodified vinyl alkyl ether resin, the obtainable film forms a satisfactory pattern configuration and is resistant to cracks. The vinyl alkyl ether resins modified at both terminals show higher compatibility with the resin components than without modified terminals, and they also provide higher solubility in developers and remarkably improved resolution.

The states of the terminal-modified vinyl alkyl ether resins at room temperature are variable from fluids to soft resinous forms depending on the polymerization degree, and should be selected appropriately. Accordingly, n in Formula (5) is not particularly limited, but is usually an integer of 1 or greater, preferably from 1 to 100, more preferably from 10 to 50.

The radiation-sensitive positive resin composition may contain the terminal-modified vinyl alkyl ether resin in an amount of 1 to 50 parts by mass, preferably 2 to 20 parts by mass, particularly preferably 5 to 20 parts by mass based on 100 parts by mass of the component (A). Above this level, the contrast between the exposed regions and the unexposed regions is not obtained to result in bad pattern configuration.

### (Polyether resins)

Examples of the terminal-modified polyether resins include polymers and oligomers represented by Formula (6a) and/or Formula (6b):

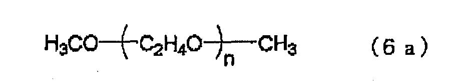

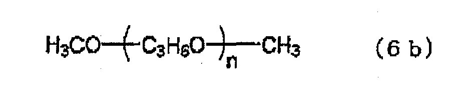

When the radiation-sensitive positive resin composition contains the terminal-modified polyether resin, the obtainable film forms a satisfactory pattern configuration and is resistant to cracks. The polyether resins modified at both terminals moderately limit the solubility in developers as compared with polyether resins without modified terminals, and consequently the resolution is ensured.

The states of the terminal-modified polyether resins at room temperature are variable from fluids to crystals depending on the polymerization degree, and should be selected appropriately. Accordingly, n in Formulae (6a) and (6b) is not particularly limited, but is usually an integer of 1 or greater, preferably from 1 to 30, more preferably from 10 to 20.

The radiation-sensitive positive resin composition may contain the terminal-modified polyether resin in an amount of 1 to 50 parts by mass, preferably 2 to 20 parts by mass, particularly preferably 5 to 20 parts by mass based on 100 parts by mass of the component (A) . Above this level, the contrast between the exposed regions and the unexposed regions is not obtained to result in bad pattern configuration.

### [Transfer film]

The transfer film according to the present invention includes a support film and a resin film on the support film. The resin film is formed from the above-described radiation-sensitive positive resin composition. The transfer film may be manufactured by applying the composition on the support film, followed by drying.

The application methods include spin coating, roll coating, screen printing and use of an applicator. The materials of the support films are not particularly limited as long as they have strength enough to endure stress during the fabrication and use of the transfer film.

The resin film of the transfer film may be 20 to 200 µm in thickness. Releasing the support film from the transfer film produces a radiation-sensitive positive resin film. Like the resin composition described above, this resin film may be used for producing platings.

### [Process for producing platings]

The process for producing platings according to the present invention comprises the steps of:
(1) providing a resin film on a wafer having a barrier metal layer, the resin film comprising the radiation-sensitive positive resin composition;
(2) exposing the resin film to light and developing a latent image to form a pattern;
(3) depositing an electrode material by electroplating using the pattern as a template; and
(4) releasing the remaining resin film and etching the barrier metal layer.

### <Formation of radiation-sensitive resin film>

The radiation-sensitive positive resin composition is applied to a predetermined substrate, particularly of an electronic part, and is dried (the solvent is removed by heating or reducing the pressure) to form a radiation-sensitive resin film (resist film). The film thickness is from 5 to 60 µm, preferably 10 to 30 µm, When the resist film thickness is less than this, plating often results in insufficiently high bumps. When the film thickness is more than that described above, the resin film tends to be nonuniform. Alternatively, a resist film may be provided on a substrate by transferring a dry resist film of the radiation-sensitive positive resin composition onto the substrate. Namely, the transfer film of the invention facilitates the production of the resist film.

The application methods for the radiation-sensitive positive resin composition include spin coating, roll coating, screen printing and use of an applicator. After the radiation-sensitive positive resin composition is applied on the substrate, the film is dried (prebaked). The drying conditions are variable depending on the types and amounts of components in the composition, and the film thickness. Generally, the drying (prebaking) is performed at 70 to 140°C, preferably 100 to 120°C, for about 5 to 60 minutes. An insufficient prebaking time tends to cause bad adhesion of the resist during development, and prolonged prebaking tends to result in bad solubility of the exposed regions and reduced resolution.

### <Irradiation (exposure)>

The resist film is irradiated with ultraviolet light or visible light (300 to 500 nm) through a predetermined pattern mask to selectively expose bump-forming regions. The sources of radiation include low-pressure mercury lamps, high-pressure mercury lamps, ultrahigh-pressure mercury lamps, metal halide lamps and argon gas lasers. The radiation used herein refers to ultraviolet light, visible light, far ultraviolet light, X-ray, electron beams and the like. The radiation dose is variable depending on the types and amounts of components in the composition, and the film thickness. In the case of an ultrahigh-pressure mercury lamp, the dose is in the range of 100 to 3,000 mJ/cm².

### <PEB>

The exposure is followed by heating (PEB) of the resist film to accelerate the decomposition of the acid-dissociative functional groups by the acid. The heating conditions are variable depending on the types and amounts of components in the composition, and the film thickness. Generally, the heating is performed at 80 to 140°C, preferably 90 to 120°C, for about 5 to 60 minutes.

### <Development>

After PEB, the latent image is developed using an aqueous alkaline solution as a developer. As a result, the exposed regions are dissolved and removed, while the unexposed regions remain to form the desired resist pattern. The developing methods are not particularly limited and include dropping, dipping, paddling and spraying.

Examples of the developers include aqueous alkaline solutions of sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrole, piperidine, 1,8-diazabicyclo[5.4.0]-7-undecene and 1,5-diazabicyclo[4.3.0]-5-nonane. These aqueous alkaline solutions may contain appropriate amounts of water-soluble organic solvents such as methanol and ethanol, and surfactants.

In the invention, the term "alkali-solubility" means solubility in the aqueous alkaline solution, for example a 5% aqueous sodium hydroxide solution.

The developing time varies depending on the types and amounts of components in the composition, and the dry film thickness. For example, it is usually in the range of 1 to 30 minutes. After the development, the patterned film is preferably washed with running water for 30 to 90 seconds and is air dried using an air gun or is dried using an oven or a spin-dryer.

### <Electroplating>

The substrate with the patterned film is soaked in an electroplating solution, and electroplating is carried out under recommended plating conditions (temperature and time) . Consequently, platings are plated in the resist pattern as a template, The plating solutions include gold plating solutions, solder plating solutions, copper plating solutions and silver plating solutions.

### <Releasing>

After the electroplating, the substrate is soaked in a releasing solution at room temperature to 80°C for 1 to 10 minutes with stirring. As a result, the resist pattern (unexposed regions) on the substrate is released, and a protruded pattern of platings (bumps) is formed.

Examples of the releasing solutions include ethylene glycol alkyl ethers such as ethylene glycol monomethyl ether, ethylene glycol monoethyl ether, ethylene glycol monopropyl ether and ethylene glycol monobutyl ether; diethylene glycol dialkyl ethers such as diethylene glycol dimethyl ether, diethylene glycol diethyl ether, diethylene glycol dipropyl ether and diethylene glycol dibutyl ether; ethylene glycol alkyl acetates such as methyl cellosolve acetate and ethyl cellosolve acetate; propylene glycol alkyl ether acetates such as propylene glycol monomethyl ether acetate, propylene glycol monoethyl ether acetate and propylene glycol monopropyl ether acetate; ketones such as acetone, methyl ethyl ketone, cyclohexanone and methyl amyl ketone; aromatic hydrocarbons such as toluene and xylene; cyclic ethers such as dioxanes; and esters such as methyl 2-hydroxypropionate, ethyl 2-hydroxypropionate, ethyl 2-hydroxy-2-methylpropionate, ethyl 3-ethoxypropionate, ethyl ethoxyacetate, ethyl oxyacetate, methyl 2-hydroxy-3-methylbutanoate, 3-methoxybutyl acetate, 3-methyl-3-methoxybutyl acetate, ethyl formate, ethyl acetate, butyl acetate, methyl acetoacetate and ethyl acetoacetate. These releasing solutions may be used singly or in combination of two or more kinds.

Through the steps described above, bumps are formed on the substrate with high precision and small pitches.

### <Reflowing>

In the case of solder bumps, the bumps are reflowed to form spherical bumps. Specifically, after the resist is released, the substrate is conveyed through a reflow furnace at room temperature to 500°C for 1 to 60 minutes to heat and melt the solder bumps on the substrate into a pattern of spherical solder platings (bumps).

### EXAMPLES

Hereinbelow, the present invention will be described by Examples without limiting the invention. Unless otherwise mentioned, part (s) and % refer to part (s) by mass and % by mass.

### <Synthesis of polymer (A)>

### [Synthetic Example 1]

27 g of p-isopropenyl phenol, 26 g of isobornyl acrylate, 22 g of benzyl acrylate, 25 g of t-butyl acrylate, 1 g of 1,6-hexanediol diacrylate and 0.2 g of t-dodecylmercaptan were mixed with 100 g of propylene glycol monomethyl ether. The mixture was stirred to give a uniform solution. Nitrogen gas was bubbled through the solution for 30 minutes, and 3 g of 2,2-azobisisobutyronitrile (AIBN) was added. While the nitrogen gas was bubbled through the solution, polymerization was performed at 70°C for 3 hours, and 1 g of AIBN was added followed by reaction at 70°C for 3 hours. While the nitrogen gas was bubbled through the solution, the polymerization was carried out at 80°C for 2 hours and at 100°C for 1 hour. After the completion of the polymerization, the reaction solution was mixed with an excess of hexane to precipitate the polymer formed. The polymer was redissolved in tetrahydrofuran and was reprecipitated in hexane several times to remove the unreacted monomers. The polymer was dried at 50°C under reduced pressure to give a polymer (A1) having a terminal -SR group.

### <Synthetic Examples 2 to 16>

Polymers (A2) to (A15) with a terminal -SR group, and a polymer (A16) without a -SR group were synthesized in the same manner as in Synthetic Example 1, except that the types and amounts of the compounds were changed as shown in Table 1.

**Table 1**

| Polymer | Average molecular weight | Components (unit: g) | | | | | | | | |
|---|---|---|---|---|---|---|---|---|---|---|
| | | (a) | (b) | (c) | (d) | (e) | (f) | (g) | (h) | (i) |
| A1 | 15,000 | 27 | 26 | 22 | 25 | 0 | 1 | 1 | 0 | 0 |
| A2 | 39,000 | 27 | 26 | 22 | 25 | 0 | 1 | 0-5 | 0 | 0 |
| A3 | 41,000 | 27 | 26 | 22 | 25 | 0 | 1 | 0-4 | 0 | 0 |
| A4 | 44,000 | 27 | 26 | 22 | 25 | 0 | 1 | 0.3 | 0 | 0 |
| A5 | 54,000 | 27 | 26 | 22 | 25 | 0 | 1 | 0-2 | 0 | 0 |
| A6 | 55,000 | 27 | 26 | 22 | 25 | 0 | 1 | 0.1 | 0 | 0 |
| A7 | 65,000 | 27 | 26 | 22 | 25 | 0 | 1 | 0.05 | 0 | 0 |
| A8 | 11,000 | 33 | 8 | 21 | 28 | 10 | 1 | 1 | 0 | 0 |
| A9 | 33,000 | 33 | 8 | 21 | 28 | 10 | 1 | 0.5 | 0 | 0 |
| A10 | 40,000 | 33 | 8 | 21 | 28 | 10 | 1 | 0.2 | 0 | 0 |
| A11 | 43,000 | 33 | 8 | 21 | 28 | 10 | 1 | 0.1 | 0 | 0 |
| A12 | 10,000 | 27 | 26 | 22 | 25 | 0 | 1 | 0 | 1 | 0 |
| A13 | 28,000 | 27 | 26 | 22 | 25 | 0 | 1 | 0 | 0.5 | 0 |
| A14 | 37,000 | 27 | 26 | 22 | 25 | 0 | 1 | 0 | 0.2 | 0 |
| A15 | 50,000 | 27 | 26 | 22 | 25 | 0 | 1 | 0 | 0 | 1 |
| A16 | 120,000 | 27 | 26 | 22 | 25 | 0 | 1 | 0 | 0 | 0 |

| | | | | | | | | | | |
|---|---|---|---|---|---|---|---|---|---|---|
| (a) p-Isopropenyl phenol manufactured by MITSUI CHEMICALS, INC. (b) Isobornyl acrylate manufactured by OSAKA ORGANIC CHEMICAL INDUSTRY LTD. (c) Phenoxypolyethylene glycol acrylate manufactured by OSAKA ORGANIC CHEMICAL INDUSTRY LTD. (d) t-Butyl acrylate manufactured by OSAKA ORGANIC CHEMICAL INDUSTRY LTD. (e) p-Hydroxyphenyl methacrylamide manufactured by SHOWA HIGHPOLYMER CO., LTD. (f) 1,6-Hexanediol diacrylate manufactured by KYOEISHA CHEMICAL Co., LTD. (g) t-Dodecylmercaptan manufactured by Chevron Corporation (h) n-octadecylmercaptan manufactured by Wako Pure Chemical Industries Ltd. (i) Terpinolene manufactured by YASUHARA CHEMICAL CO., LTD. | | | | | | | | | | |

### [Example 1]

### (Preparation of radiation-sensitive positive resin composition for producing platings)

100 parts by mass of the polymer (A1), 3 parts by mass of 4,7-di-n-butoxynaphthyl tetrahydrothiophenium trifluoromethanesulfonate as acid generator (B) and 0.04 part by mass of acid diffusion controller 2,4,6-tri(2-pyridyl)-s-triazine (1% by mass ethyl lactate solution) were dissolved in 150 parts by mass of propylene glycol monomethyl ether acetate as organic solvent (C). The solution was filtered through a 3-µm Teflon® membrane filter to obtain a resin composition.

### (Preparation of gold-sputtered substrate)

Chromium was sputtered in an approximate thickness of 500 Å on a 4-inch silicon wafer substrate, and gold was sputtered thereon in a thickness of 1,000 Å to form conductive layers. This substrate with the conductive layers will be referred to as the "gold-sputtered substrate".

### (Formation of pattern)

The resin composition was applied to the gold-sputtered substrate using a spin coater, and the coating was dried over a hot plate at 120°C for 5 minutes to form a resin film 25 µm in thickness. The film was irradiated with ultraviolet light from an ultrahigh-pressure mercury lamp (HBO manufactured by OSRAM, output: 1, 000 W) at a dose of 300 to 1500 mJ/cm² through a pattern mask. The dose was read with an illuminometer (UV-M10 manufactured by ORC MANUFACTURING C0. , LTD.) connected with a probe (UV-35, photoreceiver). After the irradiation, the film was subjected to PEB over a hot plate at 100°C for 5 minutes. The latent image was developed by soaking the film in a 2.38% by mass aqueous tetramethylammonium hydroxide solution at room temperature for 1 minute, followed by washing with running water and nitrogen blowing to produce a pattern-This substrate with the pattern will be referred to as the "patterned substrate".

### (Formation of platings)

Prior to electroplating, the patterned substrate was pretreated by oxygen plasma ashing (output: 100 W, oxygen flow rate: 100 ml, treatment time: 1 minute) to make the surface hydrophilic. The substrate was electroplated by being soaked in 1 liter of a cyanide-free gold plating solution (ECF-88K manufactured by N. E. CHEMCAT CORPORATION) at a plating bath temperature of 70°C and a current density of 0.8 A/dm² for about 30 minutes or by being soaked in 1 liter of a gold cyanide plating solution (TEMPELEX 401 manufactured by Electroplating Engineers of Japan, Ltd.) at a plating bath temperature of 50°C and a current density of 0.6 A/dm² for about 50 minutes. Consequently, platings as bumps with a height of 15 to 18 µm were formed. The platings were washed with running water and were dried by blowing nitrogen gas. The substrate was soaked in N-methylpyrrolidone at room temperature for 20 minutes to release the resin film, and the substrate with the platings resulted. This substrate with the platings will be referred to as the "plated substrate".

### (Evaluation)

### (1) Sensitivity

The resin composition on the gold-sputtered substrate was irradiated through a mask designed for producing a pattern with pitches of 40 µm (30-µm wide apertures and 10-µm wide resists) . The exposure dose was determined to be optimum when the bottom of the apertures in the resin film was 30 µm in width. The sensitivity was evaluated based on this optimum dose. The results are show in Table 3.

### (2) Resolution

The resin composition on the gold-sputtered substrate was irradiated through two types of masks separately, wherein each mask had a pattern with pitches of 40 µm. One was designed for producing a pattern of 30-µm wide apertures and 10-µm wide resists, and the other for producing a pattern of 32-µm wide apertures and 8-µm wide resists. The two patterned substrates were observed with an optical microscope and a scanning electron microscope to evaluate the resolution based on the following criteria. The results are shown in table 3.
AA: The pattern of 32-µm wide apertures and 8-µm wide resists was formed.
BB: The pattern of 30-µm wide apertures and 10-µm wide resists was formed, but the pattern of 32-µm wide apertures and 8-µm wide resists was not formed.
CC: These patterns with pitches of 40 µm were poorly reproduced or were not formed.

### (3) Adhesion durability

The patterned substrate was plated with the gold cyanide plating solution to form platings as bumps, and the platings were washed with running water and were dried by blowing nitrogen gas. The resin film was not released from the substrate. The substrate surface was observed with an optical microscope to evaluate the adhesion durability based on the following criteria. The results are shown in table 3.
AA: The resist around the bumps was not lifted.
BB: The resist around the bumps was locally lifted.
CC: The resist was lifted around all the bumps.

### (4) Test of tendency to contaminate plating solutions

The patterned substrate was soaked in the cyanide-free gold plating solution for 6 hours, and was thereafter electroplated with the same plating solution to form platings as bumps. The platings were washed with running water and were dried by blowing nitrogen gas. The resin film was released from the substrate. The gold platings were measured for surface hardness using a hardness tester, and the surface hardness was evaluated relative to that of platings produced without soaking the patterned substrate in the plating solution.
AA: The hardness was comparable to that obtained without soaking (the composition did not contaminate the plating solution).
CC: The hardness was substantially different from that obtained without soaking (the composition contaminated the plating solution).

### (5) Cracking resistance

The patterned substrate was plated with the cyanide-free gold plating solution to form platings as bumps in the same manner as Formation of platings described hereinabove. The platings were washed with running water and were dried by blowing nitrogen gas. The resin film was not released from the substrate. The substrate was allowed to stand in a clean room at 23°C and about 45% RH. The substrate surface was observed with an optical microscope after 3 hours and 24 hours to evaluate the cracking resistance based on the following criteria. The results are shown in Table 3.
AA: The patterned resin film was not cracked in 24 hours.
BB: The patterned resin film was not cracked in 3 hours but was cracked in 24 hours.
CC: The patterned resin film was cracked in 3 hours.

Herein, the patterned resin film was the resist pattern.

### (6) Deposit configuration (A)

The patterned substrate having a pattern with pitches of 40 µm (30-µm wide apertures and 10-µm wide resists) was plated with the cyanide-free gold plating solution. The plated substrate was observed with an optical microscope and a scanning electron microscope to evaluate the deposit configuration based on the following criteria. The results are shown in Table 3.
AA: The platings were plated with high fidelity to the pattern configuration of the resin film. The indentation was nil or less than 0.5 µm.
BB: The platings indented the apertures in the resin film pattern by 0.5 to 1.0 µm.
CC: The platings indented the apertures in the resin film pattern by more than 1.0 µm.

### (7) Deposit configuration (B)

The patterned substrate having a pattern with pitches of 40 µm (30-µm wide apertures and 10-µm wide resists) was plated with the cyanide-free gold plating solution. The plated substrate was observed with an optical microscope and a scanning electron microscope to evaluate the deposit configuration based on the following criteria. The results are shown in Table 3.
AA The bottom of the platings faithfully reproduced the shape of the apertures in the resin film without leaking under the resin film pattern.
BB: The bottom of the platings faithfully reproduced the shape of the apertures in the resin film but the platings leaked under the resin film pattern.
CC: The bottom of the platings was not faithful to the shape of the apertures in the resin film and the platings leaked under the resin film pattern.

### [Examples 2 to 23]

Patterns and platings were produced and evaluated in the same manner as in Example 1, except that the amounts of the components were changed as shown in Table 2. The results are shown in Table 3. The additive (E1) was a terminal-modified vinyl alkyl ether resin (Lutonal M40 manufactured by BASF) represented by Formula (5). The additive (E2) was a terminal-unmodzfied vinyl alkyl ether resin (TOE-2000H manufactured by KYOWA HAKKO CHEMICAL CO., LTD.) represented by Formula (5). The additive (E3) was a terminal-modified polyether resin (MM-1000 manufactured by NOF CORPORATION) represented by Formula (6a). The additive (E4) was a terminal-modified polyether resin (DM-18 manufactured by NOF CORPORATION) represented by Formula (6b).

### [Comparative Examples 1 to 4]

Patterns and platings were produced and evaluated in the same manner as in Example 1, except that the amounts of the components were changed as shown in Table 2. The results are shown in Table 3.

**Table 2**

| | Polymer (A) | | Acid generator (B) | Organic solvent (C) | Acid diffusion controller | Additive (E) | | Additive (F) | |
|---|---|---|---|---|---|---|---|---|---|
| | Type | Parts | Parts | Parts | Parts | Type | Parts | Type | Parts |
| Ex. 1 | A1 | 100 | 3 | 150 | 0.04 | E2 | 5 | None | |
| Ex. 2 | A1 | 100 | 5 | 150 | 0.04 | None | | None | |
| Ex. 3 | A2 | 100 | 3 | 150 | 0.04 | E2 | 5 | None | |
| Ex. 4 | A3 | 100 | 3 | 150 | 0.04 | E2 | 5 | None | |
| Ex. 5 | A4 | 100 | 3 | 150 | 0.04 | E2 | 5 | None | |
| Ex. 6 | A5 | 100 | 3 | 150 | 0.04 | E2 | 5 | None | |
| Ex. 7 | A5 | 100 | 3 | 150 | 0.04 | E1 | 5 | None | |
| Ex. 8 | A5 | 100 | 3 | 150 | 0.04 | E3 | 5 | None | |
| Ex. 9 | A5 | 100 | 3 | 150 | 0.04 | E4 | 5 | None | |
| Ex. 10 | A5 | 100 | 5 | 150 | 0.04 | None | | None | |
| Ex. 11 | A6 | 100 | 3 | 150 | 0.04 | E2 | 5 | None | |
| Ex. 12 | A6 | 100 | 5 | 150 | 0.04 | None | | None | |
| Ex. 13 | A7 | 100 | 3 | 150 | 0.04 | E2 | 5 | None | |
| Ex. 14 | A8 | 100 | 3 | 150 | 0.04 | E2 | 5 | None | |
| Ex. 15 | A9 | 100 | 3 | 150 | 0.04 | E2 | 5 | None | |
| Ex. 16 | A10 | 100 | 3 | 150 | 0.04 | E2 | 5 | None | |
| Ex. 17 | A11 | 100 | 3 | 150 | 0.04 | E2 | 5 | None | |
| Ex. 18 | A12 | 100 | 3 | 150 | 0.04 | E2 | 5 | None | |
| Ex. 19 | A13 | 100 | 3 | 150 | 0.04 | E2 | 5 | None | |
| Ex. 20 | A14 | 100 | 3 | 150 | 0.04 | E2 | 5 | None | |
| Ex. 21 | A14 | 100 | 3 | 150 | 0-04 | E1 | 5 | None | |
| Ex. 22 | A14 | 100 | 3 | 150 | 0.04 | E3 | 5 | None | |
| Ex. 23 | A14 | 100 | 3 | 150 | 0.04 | E4 | 5 | None | |
| Comp. Ex. 1 | A15 | 100 | 3 | 150 | 0.04 | E2 | 5 | None | |
| Comp. Ex. 2 | A16 | 100 | 3 | 150 | 0.04 | E2 | 5 | F1 | 1 |
| Comp. Ex. 3 | A16 | 100 | 3 | 150 | 0.04 | E2 | 5 | F1 | 0.2 |
| Comp. Ex. 4 | A16 | 100 | 3 | 150 | 0.04 | E2 | 5 | F2 | 0.2 |

| | | | | | | | | | |
|---|---|---|---|---|---|---|---|---|---|
| Acid generator (B): 4,7-Di-n-butoxynaphthyl tetrahydrothiophenium trifluoromethanesulfonate Organic solvent (C): Propylene glycol monomethyl ether Acid diffusion controller: 2,4,6-Tri(2-pyridyl)-s-triadine Additive (E1): Terminal-modified vinyl alkyl ether resin (Lutonal M40 manufactured by BASF) Additive (E2): Terminal-unmodified vinyl alkyl ether resin (TOE-2000H manufactured by KYOWA HAKKO CHEMICAL CO., LTD.) Additive (E3): Terminal-modified polyether resin (MM-1000 manufactured by NOF CORPORATION) Additive (E4): Terminal-modified polyether resin (DM-18 manufactured by NOF CORPORATION) Additive (F1): t-Dodecylmercaptan manufactured by Chevron Corporation Additive (F2): γ-Mercaptopropyltrimethoxysilane manufactured by Dow Corning Toray Silicone Co., Ltd. | | | | | | | | | |

**Table 3**

| | Sensitivity (mJ/cm²) | Resolution | Adhesion durability | Plating solution contamination test | Cracking resistance | Deposit configuration | |
|---|---|---|---|---|---|---|---|
| | | | | | | A | B |
| Ex. 1 | 300 | AA | AA | AA | AA | BB | AA |
| Ex. 2 | 250 | AA | AA | AA | BB | BB | BB |
| Ex. 3 | 300 | AA | AA | AA | AA | BB | AA |
| Ex. 4 | 300 | AA | AA | AA | AA | BB | AA |
| Ex. 5 | 300 | AA | AA | AA | AA | BB | AA |
| Ex. 6 | 300 | AA | AA | AA | AA | AA | AA |
| Ex. 7 | 400 | BB | AA | AA | AA | AA | AA |
| Ex. 8 | 250 | AA | AA | AA | AA | BB | AA |
| Ex. 9 | 300 | AA | AA | AA | AA | BB | AA |
| Ex. 10 | 250 | AA | AA | AA | AA | AA | AA |
| Ex. 11 | 300 | AA | AA | AA | AA | AA | AA |
| Ex. 12 | 250 | AA | AA | AA | AA | AA | AA |
| Ex. 13 | 300 | AA | BB | AA | AA | AA | AA |
| Ex. 14 | 400 | AA | AA | AA | BB | BB | AA |
| Ex. 15 | 400 | AA | AA | AA | BB | BB | AA |
| Ex, 16 | 400 | AA | AA | AA | BB | AA | AA |
| Ex. 17 | 400 | AA | AA | AA | AA | AA | AA |
| Ex. 18 | 300 | AA | BB | AA | AA | AA | AA |
| Ex. 19 | 300 | AA | AA | AA | AA | AA | AA |
| Ex. 20 | 300 | AA | AA | AA | AA | AA | AA |
| Ex. 21 | 400 | BB | AA | AA | AA | AA | AA |
| Ex. 22 | 250 | AA | AA | AA | AA | BB | AA |
| Ex. 23 | 300 | AA | AA | AA | AA | BB | AA |
| Comp. Ex. 1 | 350 | AA | CC | AA | AA | AA | AA |
| Comp. Ex. 2 | 350 | AA | AA | CC | AA | AA | AA |
| Comp. Ex. 3 | 350 | AA | AA | CC | AA | AA | AA |
| Comp. Ex. 4 | 350 | AA | AA | CC | AA | AA | AA |

A radiation-sensitive positive resin composition is excellent in sensitivity, resolution and adhesion to a substrate and is developed to form clear apertures without residues. The composition does not contaminate a plating solution and is capable of forming a resin film (resist) that is resistant to cracks after plating, resistant to indentation by platings, and resistant to lifting. A transfer film has the composition. A process of the invention produces thick platings as bumps or wirings with high precision.

The radiation-sensitive positive resin composition for producing platings includes a polymer (A) that has at least one end terminated with -SR (wherein R is a linear or branched alkyl group of 1 to 20 carbon atoms, a cyclic alkyl group of 3 to 20 carbon atoms, or a derivative thereof) and includes a structural unit having an acid-dissociative functional group which is dissociated by an acid to yield an acidic functional group; a radiation-sensitive acid generator (B); and an organic solvent (C).

## Claims

1. A radiation-sensitive positive resin composition for producing platings, comprising:
a polymer (A) that has at least one end terminated with -SR (wherein R is a linear or branched alkyl group of 1 to 20 carbon atoms, a cyclic alkyl group of 3 to 20 carbon atoms, or a derivative thereof) and includes a structural unit having an acid-dissociative functional group which is dissociated by an acid to yield an acidic functional group;
a radiation-sensitive acid generator (B); and
an organic solvent (C).

2. The radiation-sensitive positive resin composition for producing platings according to claim 1, wherein the polymer (A) is obtained using a chain transfer agent represented by Formula (1):
R-SH (1)
wherein R is a linear or branched alkyl group of 1 to 20 carbon atoms, a cyclic alkyl group of 3 to 20 carbon atoms, or a derivative thereof.

3. The radiation-sensitive positive resin composition for producing platings according to claim 1 or 2, wherein the polymer (A) further includes a structural unit represented by Formula (2) and/or a structural unit represented by Formula (3): 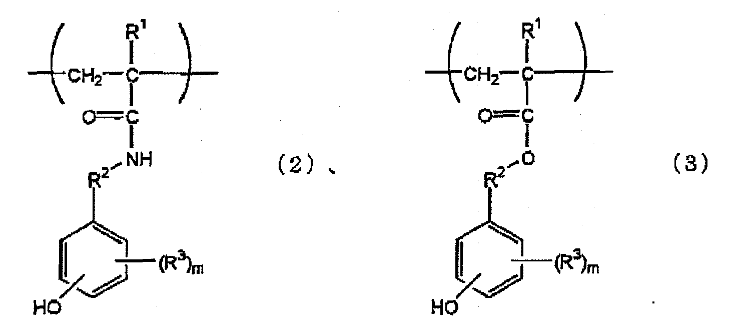 wherein R¹ are independently a hydrogen atom or a methyl group, R² are each -(CH₂)ⱼ- (wherein j is an integer of 0 to 3), R³ are independently a hydrogen atom or an alkyl group of 1 to 4 carbon atoms, and m are each an integer of 1 to 4.

4. The radiation-sensitive positive resin composition for producing platings according to any one of claims 1 to 3, wherein the structural unit having an acid-dissociative functional group of the polymer (A) is represented by Formula (4): 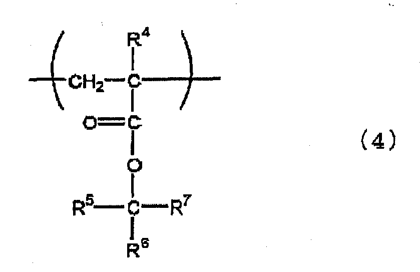 wherein R⁴ is a hydrogen atom or a methyl group; R⁵ to R⁷ are independently an alkyl group of 1 to 4 carbon atoms, an alicyclic hydrocarbon group of 4 to 20 carbon atoms, an aromatic group, or a substituted hydrocarbon group obtained by substituting at least one hydrogen atom in the above groups with a polar group other than hydrocarbon groups; and when any two of R⁵ to R⁷ are the alkyl groups or substituted alkyl groups, the alkyl chains may be linked together to form an alicyclic hydrocarbon group or a substituted alicyclic hydrocarbon group of 4 to 20 carbon atoms.

5. The radiation-sensitive positive resin composition for producing platings according to any one of claims 1 to 4, wherein the polymer (A) is a copolymer that includes a structural unit derived from a monomer with two or more ethylenically unsaturated double bonds.

6. The radiation-sensitive positive resin composition for producing platings according to any one of claims 1 to 5, wherein the composition further includes an alkali-soluble resin other than the polymer (A).

7. The radiation-sensitive positive resin composition for producing platings according to any one of claims 1 to 6, wherein the composition further includes an acid diffusion controller.

8. The radiation-sensitive positive resin composition for producing platings according to any one of claims 1 to 7, wherein the platings are bumps.

9. A resin film that is formed from the radzation-sensitive positive resin composition of any one of claims 1 to 8 and has a thickness of 20 to 100 µm.

10. A transfer film comprising a support film and the resin film of claim 9 on the support film.

11. A process for producing platings, comprising the steps of:
(1) providing a resin film on a wafer having a barrier metal layer, the resin film comprising the radiation-sensitive positive resin composition of any one of claims 1 to 8;
(2) exposing the resin film to light and developing a latent image to form a pattern;
(3) depositing an electrode material by electroplating using the pattern as a template; and
(4) releasing the remaining resin film and etching the barrier metal layer.

12. The process for producing platings according to claim 11, wherein the resin film in the step (1) is provided on the wafer by transferring the resin film of the transfer film of claim 10.
